# EUROPÄISCHE PATENTSCHRIFT

(11) **EP 2 101 554 B1**
(45) Veröffentlichungstag und Bekanntmachung des Hinweises auf die Patenterteilung: **02.01.2013**
(21) Anmeldenummer: 09405030.9
(22) Anmeldetag: 16.02.2009
(51) Int. Cl.: H05K 7/14

(54) **Gehäuse mit Leiterplatine**
Casing with circuit board
Boîtier doté d'une platine conductrice

(30) Priorität: 11.03.2008 CH 3562008
(43) Veröffentlichungstag der Anmeldung: 16.09.2009
(73) Patentinhaber: Brugg Kabel AG, 5201 Brugg (CH)
(72) Erfinder: Steiner, Walter, CH-4566 Halten (CH); Kälin, Armin, CH-8340 Hinwil (CH)
(74) Vertreter: Roshardt, Werner Alfred

(56) Entgegenhaltungen:
- EP-A1- 0 424 606
- EP-A1- 0 986 293
- DE-U1- 20 115 670
- US-A- 4 400 858
- US-B1- 7 048 564

## Beschreibung

### Technisches Gebiet

Die Erfindung betrifft eine Vorrichtung, umfassend eine in einem Gehäuse angeordnete Leiterplatine für eine elektrische und/oder elektronische Schaltung, wobei die Leiterplatine einen vorderen Bereich und einen hinteren Bereich aufweist. Des Weiteren ist ein Verfahren zur Herstellung eines Gehäuses mit einer Leiterplatine Gegenstand der Erfindung.

### Stand der Technik

Leiterplatinen für elektronische Schaltungen von elektrischen oder elektronischen Geräten werden üblicherweise in einem Gehäuse angeordnet, um sie vor Verschmutzung und mechanischen Einwirkungen zu schützen. Zudem stellen die Gehäuse auch einen Schutz für den Benutzer dar, da diese sicherstellen, dass der Benutzer nicht mit den teilweise hohen Spannungen auf der Leiterplatine in Berührung kommen kann.

Gehäuse für Leiterplatinen sind zwar in den verschiedensten Ausformungen bereits kommerziell erhältlich. Die meisten Gehäuse sind aber für den Innenbereich konzipiert und weisen lediglich eine beschränkte mechanische Festigkeit auf. Speziell robuste Gehäuse existieren zwar ebenfalls, diese sind aber meist sehr klobig und entsprechend unhandlich. Zudem sind die speziell robusten Gehäuse relativ kompliziert im Aufbau und der Herstellung und dementsprechend teuer.

Insbesondere im militärischen Umfeld werden elektrische oder elektronische Geräte im Innen- und im Aussenbereich stark beansprucht. Da die Geräte innert kurzer Zeit mehrmals an neue Standorte transportiert und neu verkabelt werden müssen, werden die Gehäuse derartiger Geräte mechanisch stark gefordert. Aufgrund der mobilen Verwendung der Geräte, sind diese z. B. beim Transport immer wieder starken Erschütterungen ausgesetzt und das ständige Ein- und Ausstecken von Steckern in den Steckerbuchsen der Geräte ist ebenfalls belastend. Hierbei sind insbesondere die relativ dünnen Leiterplatinen gefährdet. Werden die Leiterplatinen mehrmals grossen mechanischen Belastungen ausgesetzt, kann es vorkommen, dass z. B. Leiterbahnen brechen und das Gerät dadurch unbrauchbar wird. Im Aussenbereich werden an die Gehäuse nochmals erhöhte Anforderungen gestellt, da diese z. B. zusätzlichen Schutz vor Feuchtigkeit, Wasser, Hitze oder Staub bieten müssen. Um den Transportaufwand möglichst gering zu halten, ist es wünschenswert, dass die Geräte möglichst leichte und kompakte Gehäuse aufweisen, welche zudem bezüglich Robustheit befriedigen.

Es besteht daher nach wie vor Bedarf nach Gehäusen für Leiterplatinen, welche gleichzeitig robust, gut handhabbar und kostengünstig in der Herstellung sind.

Die US 7,048,564 B1 befasst sich mit einem versiegelten elektronischen Modul, mit einem einseitig offenen Gehäuse und einer mit elektronischen Komponenten bestückten Leiterplatine, welche sowohl peripher wie auch zentral im Gehäuse abgestützt ist. Die Leiterplatine weist dabei einen vorderen und einen hinteren Bereich auf, wobei sie zwischen dem vorderen Bereich und dem hinteren Bereich mechanisch im Gehäuse abgestützt ist.

Die DE 201 15 670 U1 offenbart ein Gehäuse für ein elektronisches Steuergerät in Fahrzeugen, mit einem metallischen Aussengehäuse und einem Innengehäuse aus Kunststoff. Das Gehäuse besteht aus einem becherförmigen Aussengehäuse, einer Grundplatte und einer Stirnplatte, die einen Stecksockel trägt. Das Aussengehäuse hat eine offene Seite, durch die hindurch das Innengehäuse eingeschoben wird. Das Innengehäuse besteht aus zwei rahmenartigen Gehäuseteilen zwischen denen eine Leiterplatine eingeklemmt ist. Die Leiterplatine weist dabei einen vorderen und einen hinteren Bereich auf, wobei sie zwischen dem vorderen Bereich und dem hinteren Bereich mechanisch im Gehäuse abgestützt ist.

Die EP 0 986 293 A1 beschreibt ein elektronisches Gerät, welches mit Hochfrequenzen arbeitet. Eine Sende-Empfängereinheit ist auf einer zweiseitigen, mehrschichtigen Platine aufgebaut, die in einem aus zwei Teilen bestehenden Aluminium-Gehäuse aufgenommen ist. Die Komponenten sind auf beiden Seiten der Platine angeordnet und in einer Anzahl von Unter-Modulen zusammengefasst. Die Komponenten jedes Moduls sind von internen Unterteilungswänden umgrenzt, welche integral mit den Wänden des Gehäuses ausgebildet sind. Die Platine weist einen vorderen und einen hinteren Bereich auf, wobei sie zwischen dem vorderen Bereich und dem hinteren Bereich mechanisch im Gehäuse abgestützt ist.

Die EP 0 424 606 offenbart eine modulare Gehäuseanordnung für zwei inkompatible elektrische Schaltkreise. Dabei ist eine Leiterplatine in einem Gehäuse, welches durch eine Trennwand in einen vorderen und einen hinteren Bereich unterteilt ist, offenbart. Die Leiterplatine weist dabei einen vorderen und einen hinteren Bereich auf, wobei sie zwischen dem vorderen Bereich und dem hinteren Bereich mechanisch im Gehäuse abgestützt ist. Die Leiterplatine erstreckt sich zudem durch einen Schlitz (welcher zwischen der Trennwand und einem Vorsprung ausgebildet ist) in den vorderen und den hinteren Bereich des Gehäuses.

### Darstellung der Erfindung

Aufgabe der Erfindung ist es, eine dem eingangs genannten technischen Gebiet zugehörende verbesserte Vorrichtung zu schaffen, welche einfach herstellbar und robust ist.

Die Lösung der Aufgabe ist durch die Merkmale des Anspruchs 1 definiert. Gemäss der Erfindung ist die Leiterplatine zwischen dem vorderen Bereich und dem hinteren Bereich mechanisch im Gehäuse abgestützt, wobei ein Innenraum des Gehäuses durch eine Trennwand in zwei Teilräume separiert ist und die Leiterplatine durch einen in der Trennwand eingebrachten Schlitz hindurch ragt.

Durch die Abstützung der Leiterplatine zwischen den Endbereichen wird insbesondere erreicht, dass die Leiterplatine bei starker mechanischer Einwirkung, wie z. B. Erschütterungen oder Schlägen, welche zu entsprechend hohen Beschleunigungskräften auf das Gehäuse führen, nicht übermässig durchgebogen wird. Damit wird bestmöglich verhindert, dass durch die beim Durchbiegen auftretenden Kräfte Verbindungsleitungen auf der Leiterplatine beschädigen oder dass Bauelemente auf der Leiterplatine aus ihren Lötstellen gerissen werden oder gar zerbrechen.

Damit ist es möglich, handelsübliche Leiterplatinen im Gehäuse unterzubringen und dennoch eine robuste Vorrichtung zu erhalten. Dadurch wird auch die Herstellung der erfindungsgemässen Vorrichtung bzw. eines darauf basierenden Geräts vereinfacht, da keine speziell robusten oder stabilen Leiterplatinen gefertigt werden müssen, sondern auf bekannte Leiterplatinen zurückgegriffen werden kann.

Ein Gerät, basierend auf dem erfindungsgemässen Gehäuse mit Leiterplatine, ist daher bestens geeignet für anspruchvolle Anwendungen, beispielsweise im militärischen Umfeld, in Katastrophengebieten oder bei Expeditionen.

Ein Innenraum des Gehäuses ist erfindungsgemäss durch eine Trennwand in zwei Teilräume separiert, wobei die Leiterplatine durch einen in der Trennwand eingebrachten Schlitz hindurch ragt und durch die Trennwand abgestützt ist. Damit wird eine besonders einfache Abstützung möglich, da die Leiterplatine lediglich im Schlitz platziert werden muss und die erfindungsgemässe Abstützung durch die Trennwand erfolgt. Eine aufwändige Montage von Haltevorrichtungen, wie z. B. Schrauben oder Klammern, zur Abstützung im Gehäuse kann so vermieden werden. Es ist aber grundsätzlich auch möglich, die Leiterplatine mit an sich bekannten Haltevorrichtungen, beispielsweise Schrauben, Haltestiften oder Klammern, im Gehäuse abzustützen.

Besonders bevorzugt bestehen abgesehen vom Schlitz im Wesentlichen keine weiteren Verbindungen zwischen den beiden Teilräumen des Gehäuses bzw. die Trennwand ist so ausgebildet, dass diese die beiden Teilräume bis auf den Schlitz vollständig voneinander abtrennt. Damit wird unter Anderem die Festigkeit bzw. Robustheit des Gehäuses bestmöglich verbessert, da die Trennwand eine zusätzliche Funktion als Stützelement für das Gehäuse selbst erfüllt. Es ist aber grundsätzlich auch möglich, eine Trennwand vorzusehen, welche die beiden Teilräume des Gehäuses nicht vollständig voneinander abtrennt. In diesem Fall ist aber die Funktion als Stützelement entsprechend reduziert.

Der Schlitz in der Trennwand ist insbesondere derart dimensioniert, dass dieser von einem im Schlitz vorliegenden Bereich der Leiterplatine vollständig ausgefüllt ist. Dadurch wird eine bestmögliche Abstützung der Leiterplatine durch die Trennwand erzielt, da die Leiterplatine wenigstens mit der oberen und der unteren Seite direkt an der Trennwand anliegt, was einer Durchbiegung in idealer Weise entgegenwirkt. Zudem wird die Leiterplatine so entlang einer gesamten Breite flächig abgestützt. Diese flächige Abstützung reduziert insbesondere die bei einer Abstützung durch bekannte Vorrichtungen, wie z. B. Schrauben oder Haltestifte, auftretenden punktuellen Drücke, welche bei mechanischen Einwirkungen auf die Leiterplatine entstehen. Prinzipiell kann der Schlitz aber auch grösser dimensioniert sein, so dass er von der Leiterplatine nicht vollständig ausgefüllt wird.

Liegt eine Trennwand im Gehäuse vor, so ist die Leiterplatine bevorzugt senkrecht zur Trennwand angeordnet. Da bei einer mechanischen Einwirkung auf das Gehäuse mit Leiterplatine insbesondere die Durchbiegung in einer Richtung senkrecht zur Ober- bzw. Unterseite der Leiterplatine verhindert werden soll, hat sich gezeigt, dass eine senkrecht zur Leiterplatine bzw. deren Ober- oder Unterseite angeordnete Trennwand eine bestmögliche Abstützung ermöglicht. Die Trennwand kann somit verhältnismässig dünn ausgebildet sein und dennoch eine ausreichende Stabilität bzw. Abstützung gewährleisten, da die auftretenden Kräfte hauptsächlich parallel zur Ebene der Trennwand wirken. Aus analogen Gründen steht die Trennwand mit Vorteil auch senkrecht zu einer inneren Seitenfläche des Gehäuses.

Es ist jedoch auch möglich, eine Trennwand vorzusehen, welche nicht senkrecht zur Leiterplatine angeordnet ist. Dies bringt aber unter Umständen den Nachteil mit sich, dass die Trennwand eine grössere Dicke aufweisen muss, um eine ausreichende Abstützung zu ermöglichen.

In einer weiteren vorteilhaften Ausführungsform ist die Trennwand zur Fixierung in einem peripheren Bereich vollständig von einem Rahmen umfasst, welcher bevorzugt formschlüssig in einer Aussparung des Gehäuses aufgenommen ist. Gerade bei dünnen Trennwänden ist es so möglich, die Trennwand bestmöglich im Gehäuse zu befestigen, so dass diese auch bei mechanischen Einwirkungen nicht verrutscht. Insbesondere die formschlüssige Aufnahme des Rahmens mit der Trennwand in der Aussparung des Gehäuses stellt sicher, dass die Trennwand auch bei andauernden Erschütterungen oder Vibrationen stabil in der vorgesehenen Position befestigt verbleibt.

Es sind auch andere Befestigungsarten der Trennwand denkbar. Bei einer lediglich mit Schrauben oder durch Verklebung oder Verlötung befestigten Trennwand besteht aber eher die Gefahr, dass sich die Verbindung mit dem Gehäuse bei starken Vibrationen löst.

Des Weiteren besteht das Gehäuse mit Vorteil aus Metall, insbesondere aus Aluminium. Da Metalle allgemein eine hohe Festigkeit aufweisen, kann dadurch auch eine hohe Robustheit des Gehäuses erzielt werden. Falls das Gehäuse allseitig geschlossen ist, wirkt dieses aufgrund der elektrischen Leitfähigkeit der Metalle auch als Faradayscher Käfig. Dadurch lässt sich z. B. eine elektrische Schaltung auf der Leiterplatine vor elektromagnetischer Strahlung schützen.

Aluminium hat sich dabei als besonders geeignet erwiesen. Aufgrund der undurchdringlichen Oxidschicht an der Oberfläche ist Aluminium sehr korrosionsbeständig, weist aber dennoch eine akzeptabel elektrische Leitfähigkeit auf. Die relativ geringe Dichte von Aluminium gegenüber vielen anderen Metallen ergibt zudem ein geringes Gewicht für das Gehäuse. Das Aluminium kann auch mit einer Oberflächenbehandlung versehen sein zum Beispiel mit dem Alodine®-Prozess, welcher ein chromfreies Verfahren zur Bildung einer Konversionsschicht ist und sowohl einen guten Korrosionsschutz als auch einen guten Haftuntergrund für weitere Beschichtungen schafft. Die Aluminiumoberfläche kann auch vergoldet werden.

Es ist prinzipiell aber auch möglich, das Gehäuse aus einem anderen Material als Metall zu fertigen. In Frage kommen z. B. Kunststoffe oder Karbonfasern. Insbesondere letztere weisen ebenfalls eine hohe Festigkeit auf. Falls nicht leitende Materialen für das Gehäuse verwendet werden, kann dieses beispielsweise mit einer Einlage aus einem metallischen Drahtgeflecht oder einer Metallfolie versehen werden, so dass ebenfalls eine Abschirmung gegenüber elektromagnetischer Strahlung erreicht wird.

Bevorzugt besteht die Trennwand aus Metall, insbesondere aus Kupfer, und ist mit einem in der Leiterplatine eingebrachten elektrischen Kontakt, insbesondere einem Erdkontakt, elektrisch verbunden. Dadurch lässt sich die Trennwand beispielsweise direkt als Erdleiter verwenden. Aufgrund der bereits vorstehend beschriebenen Festigkeit von Metallen, ist aber gleichzeitig gewährleistet, dass die Trennwand ausreichend robust und stabil ist. Kupfer hat sich dabei als besonders geeignet erwiesen, da dieses Metall eine sehr gute Leitfähigkeit aufweist und somit auch als elektrischer Leiter geeignet ist. Da die Trennwand geschützt im Innern des Gehäuses angeordnet ist, stellt die beschränkte Oxidationsbeständigkeit von Kupfer keinen eigentlichen Nachteil dar. Es können aber auch andere Metalle eingesetzt werden. Die elektrische Verbindung zwischen dem elektrischen Kontakt der Leiterplatine und der Trennwand kann z. B. über ein elektrisches Kabel erfolgen.

In diesem Zusammenhang hat es sich als besonders vorteilhaft erwiesen, wenn der in der Leiterplatine eingebrachte elektrische Kontakt wenigstens teilweise im Schlitz der Trennwand angeordnet ist und zur elektrischen Kontaktierung mit der Trennwand verlötet ist. Damit wird die elektrische Kontaktierung zwischen dem in der Leiterplatine eingebrachten elektrischen Kontakt und der Trennwand besonders einfach, da keine elektrischen Kabel oder dergleichen benötigt werden. Zudem wird durch eine direkte Verlötung des in der Leiterplatine eingebrachten elektrischen Kontakts mit der Trennwand eine besonders stabile Verbindung bzw. ein besonders zuverlässiger elektrischer Kontakt erhalten.

Insbesondere von Vorteil ist es, wenn, wie vorstehend bereits beschrieben, zusätzlich der Schlitz in der Trennwand derart dimensioniert ist, dass dieser von einem im Schlitz vorliegenden Bereich der Leiterplatine vollständig ausgefüllt ist. In diesem Fall wird eine mechanisch äusserst stabile und sichere Verbindung bzw. Kontaktierung zwischen dem in der Leiterplatine eingebrachten elektrischen Kontakt und der Trennwand erhalten.

Bevorzugt sind zudem die Trennwand und das Gehäuse elektrisch verbunden. Damit lässt sich beispielsweise auf einfache Art und Weise eine Erdung bzw. ein elektrischer Kontakt zwischen Erde und Leiterplatine herstellen. Es ist aber auch möglich, die Trennwand und das Gehäuse elektrisch voneinander zu isolieren und die den elektrischen Kontakt auf der Leiterplatine oder die Trennwand z. B. über ein elektrisches Kabel mit einem einer Buchse oder einem Stecker am Gehäuse zu verbinden.

Die Trennwand kann also abgesehen von der Funktion als Abstützung zusätzlich als Erdleiter oder elektrischer Kontakt für die Leiterplatine wirken. Diese Vereinigung zweier Funktionen (Abstützung/elektrischer Kontakt) vereinfacht dabei insbesondere die Herstellung von äusserst robusten und kompakten Gehäusen mit Leiterplatinen.

Insbesondere ist die Leiterplatine zum Schutz vor Feuchtigkeit und Fremdkörpern wenigstens teilweise von einer Gussmasse umgeben. Dabei ist es vorteilhaft, wenigstens sämtliche elektronischen Bauteile und die elektrischen Leiterbahnen auf der Leiterplatine möglichst vollständig mit Gussmasse zu umgeben, um deren Funktion auch bei eintretender Feuchtigkeit oder sicherzustellen.

Besonders bevorzugt wird der gesamte Innenraum des Gehäuses mit Gussmasse ausgefüllt. Dadurch wird abgesehen von einem optimalen Schutz gegen Feuchtigkeit und Fremdkörpern eine zusätzliche mechanische Stabilisierung der Leiterplatine im Gehäuse erreicht.

Grundsätzlich kann die Leiterplatine mit einer beliebigen elektronischen Schaltung bestückt sein. Es hat sich jedoch gezeigt, dass das erfindungsgemässe Gehäuse mit Leiterplatine insbesondere für Blitzschutzschaltungen, welche bevorzugt zum Schutz von Computernetzwerkverbindungen dienen, geeignet ist. Derartige Blitzschutzschaltungen werden nämlich insbesondere beim Freilandbetrieb, wie z. B. bei militärischen Einsätzen oft gegeben, zum Schutz von Computersystemen benötigt. Dabei ist es unabdingbar, dass die Blitzschutzschaltungen in kompakten und robusten Gehäusen vorliegen, welche zudem eine einfache Handhabbarkeit ermöglichen und unempfindlich auf mechanische Einwirkungen sind.

Mit Vorteil ist das Gehäuse röhrenförmig mit kreisrundem Querschnitt ausgebildet und die Trennwand liegt als kreisförmige Scheibe vor, welche senkrecht zu einer Längsachse des Gehäuses ausgerichtet ist. Ein derartig geformtes Gehäuse lässt sich insbesondere einfach herstellen, ist sehr stabil und zudem gut handhabbar. Ein röhrenförmiger Körper mit kreisförmigem Querschnitt besitzt zudem bei gegebenem Materialaufwand ein maximales Flächenträgheitsmoment, was wiederum in einem optimalen Knickverhalten resultiert, welches zudem in alle radialen Richtungen gleich ist. Das Gehäuse kann anstelle eines kreisrunden Querschnitts auch einen vieleckigen, insbesonderen einen viereckigen Querschnitt besitzen.

Falls, wie vorstehend beschrieben, die Trennwand so ausgebildet ist, dass diese die beiden Teilräume des Gehäuses bis auf den Schlitz vollständig voneinander abtrennt und zusätzlich der Schlitz in der Trennwand derart dimensioniert ist, dass dieser von einem im Schlitz vorliegenden Bereich der Leiterplatine vollständig ausgefüllt ist, wird eine zusätzliche Stabilisierung des Gehäuses erreicht. Die Trennwand wirkt insbesondere in diesem Fall als Verstärkungs- bzw. Stützelement im Innern des Gehäuses.

Bei einem röhrenförmigen Gehäuse mit einer kreisförmigen Scheibe als Trennwand, welche die beiden Teilräume bis auf den Schlitz für die Leiterplatine vollständig abtrennt, lässt sich die Gussmasse bei der Herstellung zudem besonders vorteilhaft einbringen. Wird das röhrenförmige Gehäuse mit eingelegter Leiterplatine nämlich mit der Längsachse in vertikaler Richtung gehalten, lässt sich die Gussmasse durch die erste und oben liegende strirnseitige Öffnung in den ersten Teilraum des Gehäuses einfüllen. Die Trennwand verhindert dabei, dass die Gussmasse weiter nach unten fliessen kann und am anderen stirnseitigen Ende aus dem röhrenförmigen Gehäuse heraustropft. Zur Befüllung des zweiten Teilraums mit Gussmasse wird das röhrenförmige Gehäuse um 180 Grad gedreht, so dass die zweite stirnseitige Öffnung oben zu liegen kommt. Nun kann in gleicher Weise die Gussmasse in den zweiten Teilraum eingefüllt werden.

Es hat sich zudem als vorteilhaft erwiesen, das röhrenförmige Gehäuse mehrteilig auszubilden, wobei ein erster röhrenförmiger Gehäuseteil über einen inwenig und koaxial angeordneten Verbindungsring stirnseitig mit einem zweiten röhrenförmigen Gehäuseteil verbunden ist. Dies erleichtert insbesondere die Herstellung des Gehäuses mit Leiterplatine.

Bevorzugt ist der Verbindungsring mit einer ersten Hälfte kraftschlüssig und formschlüssig in einem Endbereich des ersten röhrenförmigen Gehäuseteils mit vergrösserten Innendurchmesser aufgenommen, während der Verbindungsring mit einer zweiten Hälfte gleichzeitig kraftschlüssig und formschlüssig in einem zweiten Endbereich des zweiten röhrenförmigen Gehäuseteils mit vergrösserten Innendurchmesser aufgenommen ist. Der Aussendurchmesser des Verbindungsrings ist dabei mit Vorteil geringfügig grösser als die vergrösserten Innendurchmesser der beiden Endbereiche der röhrenförmigen Gehäuseteile. Damit ist es nämlich möglich, den Verbindungsring in den beiden Endbereichen zu verklemmen. Zur Verbindung mit den beiden röhrenförmigen Gehäuseteilen kann der Verbindungsring aber beispielsweise auch stoffschlüssig mit den beiden Endbereichen verbunden werden.

Insbesondere ist dabei die kreisförmige Scheibe im Verbindungsring aufgenommen, wobei ein Durchmesser der kreisförmigen Scheibe einem Innendurchmesser des Verbindungsrings entspricht und wobei die kreisförmige Scheibe bevorzugt an einem nach innen ragenden Vorstand des Verbindungsrings anliegt. Die kreisförmige Scheibe kann aufgrund des nach innen ragenden Vorsprungs in einfacher Weise in einer definierten Lage im Verbindungsring gehalten werden. Zudem sind die beiden Gehäuseteile aufgrund der Dimensionen des Verbindungsrings und der kreisförmigen Scheibe bis auf den Schlitz für die Leiterplatine nahezu vollständig voneinander getrennt. Damit wird insbesondere die Festigkeit bzw. Robustheit des Verbindungsrings und damit auch des Gehäuses bestmöglich verbessert, da die kreisförmige Scheibe eine zusätzliche Funktion als Stützelement erfüllt.

Mit Vorteil verläuft der in der kreisförmigen Scheibe vorliegende Schlitz in nichtradialer Richtung. Damit kann die Leiterplatine in einer Ebene angeordnet werden, welche von der die Längsachse des röhrenförmigen Gehäuses enthaltenden Ebene verschiedenen ist. Oberhalb der Leiterplatine liegt somit ein grösseres Teilvolumen im Gehäuse vor als unterhalb der Leiterplatine. Dies hat den Vorteil, dass die Leiterplatine auch mit relativ voluminösen Bauteilen bestückt werden kann. Der zur Verfügung stehende Innenraum des Gehäuses wird so bestmöglich ausgenutzt, womit sich auch geringere Gehäuseabmessungen realisieren lassen.

Ein röhrenförmiges Gehäuse, welches aus zwei über einen Verbindungsring verbundenen Gehäuseteilen besteht, vereinfacht insbesondere die Herstellung. Die Leiterplatine, welche bereits mit einer elektronischen Schaltung vollständig bestückt vorliegen kann, kann in einem ersten Verfahrensschritt nämlich z. B. in den Schlitz einer kreisförmigen Scheibe eingeschoben werden und gegebenenfalls mit einem elektrischen Kontakt der Leiterplatine verbunden werden. Die kreisförmige Scheibe mit der darin angeordneten Leiterplatine kann dann in den Verbindungsring aufgenommen werden. Anschliessend wird der Verbindungsring beispielsweise mit einer ersten Hälfte in einem stirnseitigen Endbereich eines ersten röhrenförmigen Gehäuseteils verklemmt und anschliessend wird der Verbindungsring mit seiner zweiten Hälfte in einem zweiten Endbereich eines zweiten röhrenförmigen Gehäuseteils verklemmt. Zum Schluss kann wie vorstehend bereits beschrieben, eine Gussmasse eingefüllt werden.

In einer vorteilhaften Ausführungsform liegt an einer vorderen Stirnseite und/oder an einer hinteren Stirnseite des Gehäuses eine Steckerbuchse zur elektrischen Verbindung mit einem externen elektrischem Kabel vor, wobei die Steckerbuchse bevorzugt direkt auf der Leiterplatine angebracht ist. Verfügt das Gehäuse an einer vorderen Stirnseite und an einer hinteren Stirnseite des Gehäuses über eine Steckerbuchse, kann im Gehäuse z. B. eine elektronische Schaltung vorliegen, welche in Abhängigkeit eines Eingangssignals ein Ausgangssignal generiert. Ein erstes externes elektrisches Kabel, welches mit der vorderen bzw. der Eingangsbuche verbunden ist, kann in diesem Fall in einer Linie mit dem Gehäuse selbst und dem zweiten externen Kabel, welches mit der hinteren bzw. Ausgangsbuchse verbunden ist, angeordnet werden. Im Vergleich zu einem Gehäuse, bei welchem alle Ein- und Ausgangsbuchsen auf einer einzigen Gehäuseseite angeordnet sind, lassen sich so bei Verbindungsleitungen zwischen zwei Punkten mit zwischengeschalteten Gehäusen die externen Kabellängen reduzieren.

Durch eine Anbringung der Steckerbuchsen direkt auf der Leiterplatine lassen sich die Abmessungen des Gehäuses weiter reduzieren. Da die Leiterplatine erfindungsgemäss zwischen dem vorderen Bereich und dem hinteren Bereich mechanisch im Gehäuse abgestützt ist, verfügt diese auch über eine hohe Stabilität, welche die direkte Befestigung der Steckerbuchsen auf der Leiterplatine zulässt. Aufgrund der hohen Stabilität stellen auch relativ grosse Kräfte, welche beim harschen Ein- und Ausstecken von Steckern auftreten, für die Leiterplatine kein Problem dar. Das Kabel kann aber auch direkt, d. h. ohne Stecker eingelötet werden, zumindest auf der geschützten Seite.

Grundsätzlich können die Steckerbuchsen aber auch direkt am Gehäuse befestigt werden und über elektrische Leitungen mit der Leiterplatine verbunden werden.

Insbesondere verfügt das Gehäuse an einer Aussenseite einen oder mehrere Vorsprünge zur Befestigung des Gehäuses an einem Drittelement, wobei die Vorsprünge insbesondere Befestigungsbohrungen aufweisen. Dies ermöglicht z. B. die Verwendung des Gehäuses als Einschubmodul in einem Elektronikschrank. Durch die Befestigungsbohrungen kann das Gehäuse beispielsweise mit einer Schraube am Drittelement fixiert werden. Es ist aber auch denkbar, das Gehäuse an einem Drittelement festzuklemmen, z. B. mit einer Klemmbride.

In einer weiteren vorteilhaften Ausführungsform sind wenigstens zwei Leiterplatinen planparallel und beabstandet übereinender liegend angeordnet. Damit lassen sich beispielsweise mehrere Elektronikschaltungen in einem einzigen Gehäuse unterbringen. Die planparallele Anordnung der Leiterplatinen hat sich dabei im Hinblick auf den Platzbedarf als optimal erwiesen. Insbesondere vorteilhaft ist diese Ausführungsform im Zusammenhang mit Blitzschutzschaltungen für Computernetzwerkverbindungen. In einem einzigen Gehäuse können so mehrere Blitzschutzschaltungen untergebracht werden, womit sich beispielsweise mehrere Computer gleichzeitig schützen lassen.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung des Ausführungsbeispiels verwendeten Zeichnungen zeigen:
- Fig. 1: eine perspektivische Darstellung eines röhrenförmigen Gehäuses mit einer darin angeordneten Blitzschutzschaltung auf einer Leiterplatine, wobei am vorderen stirnseitigen Ende eine Steckerbuchse für ein Netzwerkkabel angeorndet ist;
- Fig. 2: ein Längsschnitt durch das Gehäuse aus Fig. 1 entlang der Linie A - B;
- Fig. 3: ein Querschnitt durch das Gehäuse aus Fig. 1 entlang der Linie C - D;
- Fig. 4: ein kreisförmige Scheibe mit einem nicht-radial verlaufenden Schlitz,;
- Fig. 5: ein Verbindungsring mit einem innenseitigen Absatz;
- Fig. 6: eine Leiterplatine mit einer Blitzschutzschaltung und zwei endseitig angeordneten Steckerbuchsen;
- Fig. 7: eine Explosionsdarstellung des Gehäuses aus Fig 1 mit kreisförmigen Scheibe und Verbindungsring;
- Fig.8: eine perspektivische Darstellung eines Gehäuses mit zwei planparallel übereinander angeordneten Leiterplatinen, welche je mit 6 Blitzschutzschaltungen bestückt sind;
- Fig. 9: eine Frontansicht des Gehäuses aus Fig. 8.

Grundsätzlich sind in den Figuren gleiche Teile mit gleichen Bezugszeichen versehen.

### Wege zur Ausführung der Erfindung

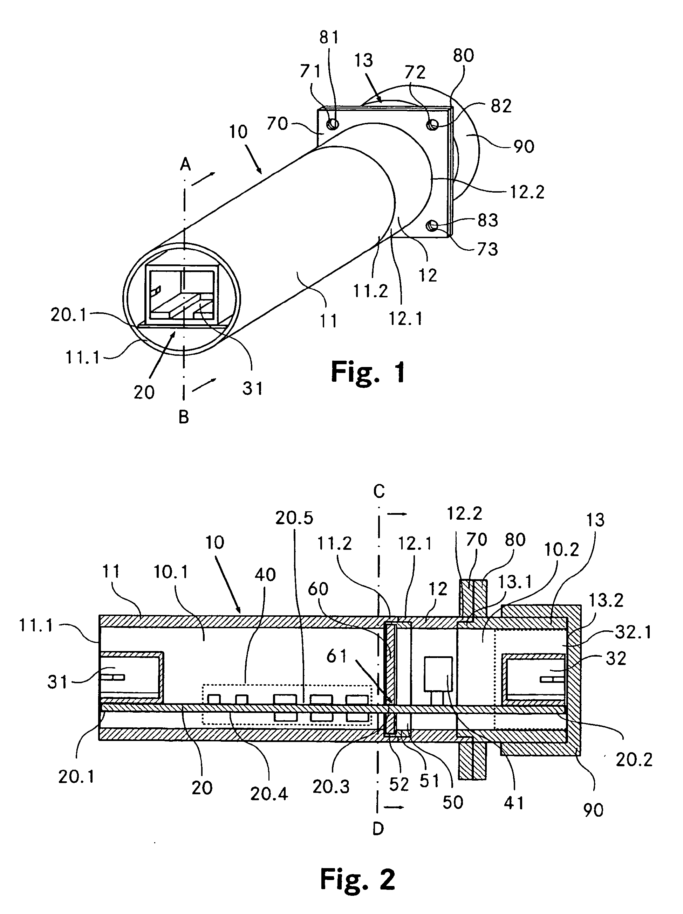

In Fig. 1 ist ein erfindungsgemässes röhrenförmiges Gehäuse 10 mit einer darin angeordneten mit einer darin angeordneten Blitzschutzschaltung für eine Computernetzwerkverbindung auf einer rechteckförmigen Leiterplatine 20 in perspektivischer Darstellung gezeigt. Ein erster und vorne liegender röhrenförmiger bzw. hohlzylindrischer Gehäuseteil 11 ragt in Fig. 1 schräg nach hinten und liegt dabei stirnseitig an einen zweiten und weiter hinten liegenden hohlzylindrischen Gehäuseteil 12 an, so dass die beiden hohlzylindrischen Gehäuseteile 11, 12 bezüglich ihren Längsachsen koaxial angeordnet sind. Am zweiten und hinteren Ende 12. 2 des zweiten hohlzylindrischen Gehäuseteils 12, welches dem ersten hohlzylindrischen Gehäuseteil 11 abgewandt ist, steht ein erster Befestigungsflansch 70 mit einer quadratischen Aussenform senkrecht vom zweiten Gehäuseteil 12 ab. Der erste Befestigungsflansch 70 liegt bezüglich der Längsrichtung des zweiten hohlzylindrischen Gehäuseteils 12 etwa in der dessen Mitte. In jedem der vier Eckbereiche des ersten Befestigungsflansches 70 ist jeweils eine Befestigungsbohrung 71...74 angeordnet, welche den ersten Befestigungsflansch 70 vollständig durchdringt. Die vier Seitenlängen des quadratischen ersten Befestigungsflansches 70 messen z. B. je 33 mm.

Direkt hinter dem zweiten hohlzylindrischen Gehäuseteil 12 schliesst ein in Fig. 1 nicht sichtbares drittes hohlzylindrisches Gehäuseteil 13 an, welches bezüglich seiner Längsachse ebenfall koaxial zum ersten und zweitem Gehäuseteil 11, 12 ausgerichtet ist. Das dritte Gehäuseteil 13 weist am ersten und vorderen Ende 13.1 (in Fig. 1 nicht sichtbar, siehe Fig. 2) einen direkt am ersten Befestigungsflansch 70 des zweiten Gehäuseteils 12 anliegenden zweiten Befestigungsflansch 80 auf, welcher senkrecht zur Längsachse des zweiten Gehäuseteils 12 von diesem absteht. Der zweite Befestigungsflansch 80 weist im Wesentlichen die gleichen Abmessungen auf, wie der erste Befestigungsflansch 70 und verfügt ebenfalls über vier weiter durchgehende Bohrungen 81...84 in den Eckbereichen. Die vier Bohrungen 81...84 des zweiten Befestigungsflansches 80 liegen dabei direkt über den vier Borungen 71...74 des ersten Befestigungsflansches 70. Durch die Bohrungen 71...74 im ersten Befestigungsflansch 70 und die weiteren Bohrungen 81...84 im zweiten Befestigungsflansch lässt sich das Gehäuse 10 z. B. mit Schrauben an einem Drittelement befestigen. Das dem zweiten Gehäuseteil 12 abgewandte zweite Ende 13. 2 (in Fig. 1 nicht sichtbar, siehe Fig. 2) des dritten hohlzylindrischen Gehäuseteils 13 ist in Fig. 1 mit einer zylinderförmigen Verschlusskappe 90 verschlossen.

Am freien und ersten Ende 11.2 des ersten Gehäuseteils 11 (in Fig. 1 ganz vorne liegend) endet die im röhrenförmigen Gehäuse 10 angeordnete Leiterplatine 20 so, dass ihr vorderes Ende 20.1 ungefähr bündig ist zum ersten Ende 11.2 des ersten Gehäuseteils 11. Im Bereich des vorderen Endes 20.1 ist zudem eine erste Steckerbuchse 31, beispielsweise in Form einer handelsüblichen RJ 45 Steckerbuchse, auf der Leiterplatine 20 angebracht. Das vorderste Ende der ersten Steckerbuchse 31 ist dabei ebenfalls bündig zum ersten Ende 11.2 des ersten Gehäuseteils 11, so dass die erste Steckerbuchse seitlich vollständig vom ersten Gehäuseteil 11 umgeben ist.

Die drei aus Aluminium bestehenden hohlzylindrischen Gehäuseteile 11, 12, 13 weisen, abgesehen von den beiden Befestigungsflanschen 70, 80, im Wesentlichen einen identischen Aussendurchmesser auf, welcher z. B. ca. 28 mm misst. Die gesamte Länge, gemessen in der Richtung der Längsachsen der drei koaxial angeordneten Gehäuseteile 11, 12, 13 beträgt beispielsweise ca. 112 mm.

In Fig. 2 ist ein Längsschnitt entlang der Linie A - B des röhrenförmiges Gehäuse 10 aus Fig. 1 dargestellt. Die drei hohlzylindrischen Gehäuseteile 11, 12, 13 sind dabei in Fig. 2 mit ihren Längsachse in horizontaler Richtung nebeneinander liegend angeordnet. Der zweite Gehäuseteil 12 liegt dabei rechts vom ersten Gehäuseteil 11 und der dritte Gehäuseteil 13 liegt auf der rechten Seite in Fig. 2, direkt rechts des zweiten Gehäuseteils. Das erste und freie Ende 11.1 des ersten Gehäuseteils 11 zeigt dabei nach links. Im Bereich des zweiten Endes 11.2 des ersten Gehäuseteils 11, weitet sich der Innendurchmesser des ersten Gehäuseteils 11 stufenartig auf. Im Bereich des ersten Endes 12.1 des zweiten Gehäuseteils 12 weitet sich der Innendurchmesser des zweiten Gehäuseteils 12 ebenfalls stufenartig auf und zwar so, dass er dem aufgeweiteten Innendurchmesser des ersten Gehäuseteils 11 im Bereich des zweiten Endes 11.2 entspricht.

Im Bereich mit aufgeweitetem Innendurchmesser des zweiten Endes 11.2 des ersten Gehäuseteils 11 ist ein zylindrischer Verbindungsring 50 mit seiner halben Breite eingepresst. Die Längsachse des Verbindungsrings 50 ist dabei ebenfalls koaxial zu den Längsachsen des ersten und des zweiten Gehäuseteils 11, 12 ausgerichtet. Der Aussendurchmesser des Verbindungsrings 50 entspricht dabei in etwa dem aufgeweiteten Innendurchmesser des ersten Gehäuseteils 11 im Bereich des zweiten Endes 11.2 bzw. dem aufgeweiteten Innendurchmesser des zweiten Gehäuseteils 12 im Bereich des ersten Endes 12.1. Die andere Hälfte des Verbindungsrings 50 ist in gleicher Weise im Bereich mit aufgeweitetem Innendurchmesser des ersten Endes 12.1 des zweiten Gehäuseteils 12 eingepresst. Der minimale Innendurchmesser des Verbindungsrings 50 Bereich der engeren Ringöffnung 51 ungefähr gleich dem minimalen Innendurchmesser der ersten beiden Gehäuseteile 11, 12. Der Verbindungsring besteht z. B. aus Kupfer und verbindet die beiden ersten Gehäuseteile kraft- und formschlüssig miteinander.

Im Bereich des zweiten Endes 12.2 des zweiten Gehäuseteils 12 weitet sich der Innendurchmesser des zweiten Gehäuseteils 12 ebenfalls stufenartig auf. Im Bereich des ersten Endes 13.1 des dritten Gehäuseteils 13 ist der Aussendurchmesser des dritten Gehäuseteils 13 stufenartig verjüngt und zwar so, dass er in etwa dem aufgeweiteten Innendurchmesser im Bereich des zweiten Endes 12.2 des zweiten Gehäuseteils 12 entspricht. Das erste und verjüngte Ende 13.1 des dritten Gehäuseteils liegt dabei im Bereich des zweiten Endes 12.2 des zweiten Gehäuseteils 12 vor und ist mit diesem kraft- und formschlüssig verpresst.

Die drei hohlzylindrischen Gehäuseteile sind daher mechanisch stabil miteinander verbunden und bilden zusammen das robuste röhrenförmige Gehäuse 10.

Wie bereits bei Fig. 1 erläutert, liegen der senkrecht vom zweiten hohlzylindrischen Gehäuseteil 12 abstehende erste Befestigungsflansch 70 und der senkrecht vom dritten hohlzylindrischen Gehäuseteil 13 abstehende zweite Befestigungsflansch 80 direkt ihren einander zugewandten Flächen direkt aufeinander.

Am zweiten Ende 13.2 des dritten Gehäuseteils 13 ist zudem eine zylinderförmige Verschlusskappe 90 angeordnet, welche den dritten Gehäuseteil 13 verschliesst. Die Verschlusskappe 90 ist dabei als einseitig verschlossener Hohlzylinder ausgebildet, welcher den dritten Gehäuseteil 13 im Bereich seines zweiten bzw. Endes 13.2 aussen umgibt. Zur Befestigung der Verschlusskappe 90 ist z. B. ein an sich bekannter Bajonettmechanismus vorgesehen, so dass ein einfaches Lösen der Verschlusskappe 90 von Hand möglich ist.

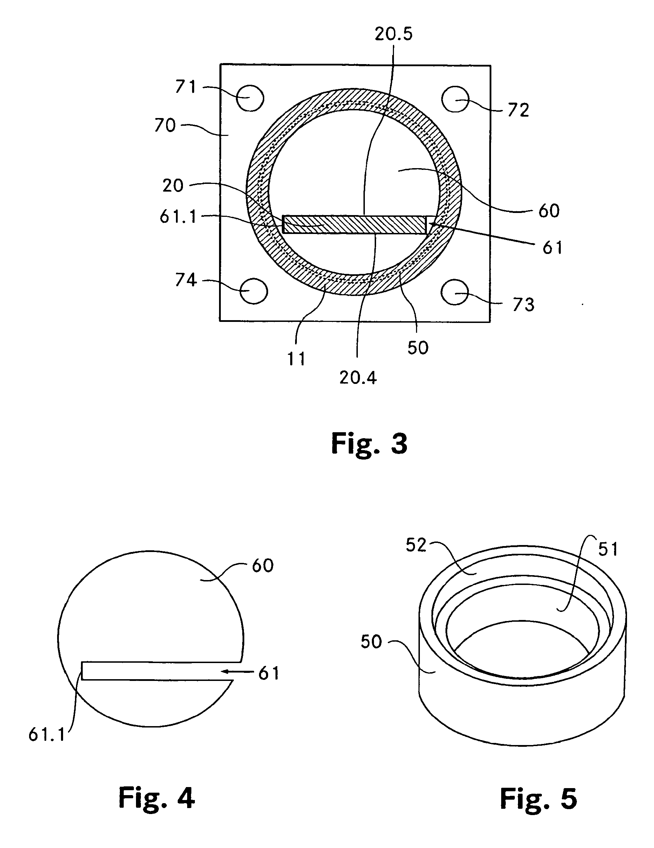

Der Inndendurchmesser des Verbindungsrings 50 weitet sich von seiner zweiten (in Fig. 2 rechts) Stirnseite zu seiner ersten Stirnseite (in Fig. 2 links) stufenartig auf, so dass rechts eine enge Ringöffnung 51 und links eine weite Ringöffnung 52 vorliegen (siehe hierzu auch Fig. 5). In der weiten Ringöffnung 52 des Verbindungsrings 50 ist eine kreisförmige Scheibe 60, z. B. aus Kupfer, eingebracht. Der Aussendurchmesser der kreisförmigen Scheibe 60 entspricht in etwa dem Innendurchmesser des Verbindungsrings 50 im Bereich der weiten Ringöffnung 52. Die kreisförmige Scheibe 60 liegt mit ihrer rechten Seite am Absatz an, welcher durch den stufenartigen Übergang zwischen weiter Ringöffnung 52 und enger Ringöffnung 51 gebildet wird. Auf der linken Seite liegt die kreisförmigen Scheibe 60 am Vorsprung an welcher durch den stufenartigen Übergang des Innendurchmessers des ersten Gehäuseteils 11 gebildet wird. Damit wird die kreisförmige Scheibe 60 im weiten Bereich 52 des Verbindungsrings 50 gehalten. Die kreisförmige Scheibe 60 trennt somit den Innenraum des Gehäuses 10 in einem ersten Teilraum 10.1 und einen zweiten Teilraum 10.2.

In einem unteren Bereich der kreisförmigen Scheibe 60 ist des Weiteren ein nicht-radial verlaufender Schlitz 61 eingebracht (siehe hierzu auch Fig. 4), welcher in einer Richtung senkrecht zur Blattebene in Fig. 2 verläuft. Der Schlitz 61 dient zur Aufnahme der rechteckförmigen Leiterplatine 20, welche in einer horizontalen Ebene vom ersten Ende 11.1 des ersten Gehäuseteils 11 durch das zweite Gehäuseteil 12 hindurch bis zum zweiten Ende 13.2 des dritten Gehäuseteils 13 verläuft. Die Leiterplatine 20 verläuft dabei etwa in der Mitte der unteren Hälfte des Gehäuses 10, in einer Richtung parallel zu den koaxialen Längsachsen der drei Gehäuseteile 11, 12, 13. Das in Fig. 2 links liegende vordere Ende 20.1 der Leiterplatine 20 ist dabei in etwa bündig mit dem ersten Ende 11.1 des ersten Gehäuseteils 11. Das in Fig. 2 rechts angeordnete hintere Ende 20.2 der Leiterplatine 20 ist entsprechend mit dem zweiten Ende 13.2 des dritten Gehäuseteils 13 bündig. Die Leiterplatine 20 wird in einem mittleren Bereich 20.3, welcher zwischen dem vorderen Ende 20.1 und dem hinteren Ende 20.2 der Leiterplatine 20 liegt durch die kreisförmige Scheibe 60 bzw. die Trennwand im Bereich des Schlitzes 61 abgestützt. Der Schlitz 61 ist so bemessen, dass die kreisförmige Scheibe 60 sowohl an die Oberseite 20.5 der Leiterplatine 20 als auch an die Unterseite 20.4 der Leiterplatine 20 an diese anliegt und die Leiterplatine 20 somit ober- und unterhalb mechanisch abstützt.

Am vorderen Ende 20.1 der Leiterplatine 20 ist zudem eine erste Steckerbuchse 31 direkt auf der Oberseite 20.5 der Leiterplatine 20 angeordnet, wobei es sich wie bei Fig. 1 bereits erwähnt z. B. um eine handelsübliche RJ 45 Steckerbuchse handelt. Die in Fig. 2 links liegende Öffnung der Steckerbuchse 31 ist dabei in etwa bündig mit den vorderen Ende 20.1 der Leiterplatine 20 bzw. mit dem ersten Ende 11.1 des ersten Gehäuseteils. In der gleichen Weise ist am hinteren Ende 20.2 der Leiterplatine 20 eine zweite Steckerbuchse 32, ebenfalls vom Typ RJ 45, an der Oberseite 20.5 der Leiterplatine 20 angebracht. Die Öffnung der zweiten Steckerbuchse 32 ist dabei ungefähr bündig zum hinteren Ende 20.2 der Leiterplatine 20 bzw. zum zweiten Ende 13.2 des dritten Gehäuseteils 13. Die beiden Zentren der Öffnungen der beiden entgegen gesetzt ausgerichteten Steckerbuchsen 31, 32 liegen in etwa auf den koaxialen Längsmittelachsen der drei Gehäuseteile 11, 12, 13.

Zwischen der ersten Steckerbuchse 31 und der kreisförmigen Scheibe 60 bzw. der Trennwand sind im ersten Teilraum 10.1 des Gehäuses 10 mehrere Elektronikbauteile 40 auf der Leiterplatine 20 angeordnet. Die Elektronikbauteile weisen eine geringe Höhe gegenüber der Leiterplatine 20 auf und sind sowohl an der Oberseite 20.5, wie auch an der Unterseite 20.4 der Leiterplatine 20 angeordnet.

Im zweiten Teilraum 10.2 des Gehäuses 10, zwischen der kreisförmigen Scheibe 60 und der zweiten Steckerbuchse 32 sind an der Oberseite 20.5 der Leiterplatine 20 weitere Elektronikbauteile 41 angeordnet, welche von der Oberseite 20.5 der Leiterplatine 20 bis über die Längsmittelachse des Gehäuses 10 nach oben ragen.

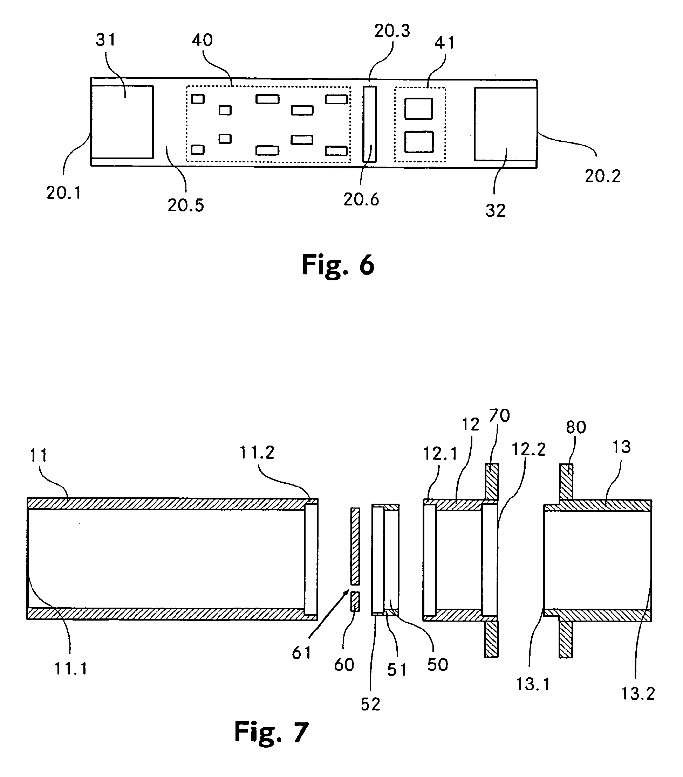

Ein in Fig. 2 nicht dargstellter elektrischer Erdkontakt 20.6 der Leiterplatine 20, welcher direkt an der Oberseite 20.5 der Leiterplatine 20 im Bereich des Schlitzes 61 bzw. des abgestützten mittleren Bereichs 20.3 der Leiterplatine angeordnet ist (siehe hierfür auch Fig. 6), ist des Weiteren mit der kreisförmigen Scheibe 60 verlötet und bildet einen elektrischen Kontakt. Da die kreisförmige Scheibe 60, wie auch die Gehäuseteile 11, 12, 13 aus einem metallischen Werkstoff bestehen, ist somit eine elektrische Erdverbindung der Leiterplatine 20 über das Gehäuse 10 herstellbar.

Die beiden Teilräume 10.1 und 10.2 des Gehäuses 10 sind mit einer in Fig. 2 nicht dargestellten Gussmasse gefüllt, welche die beiden Teilräume 10.1, 10.2 wenigstens bis zu den hinteren Enden der beiden Steckerbuchsen 31, 32 vollständig ausfüllt. Die Gussmasse liegt dabei sowohl oberhalb, wie auch unterhalb der Leiterplatine 20 vor, so dass die Leiterplatine 20 wenigstens teilweise in die Gussmasse eingebettet ist. Damit sind die Elektronikbauteile 40, 41 auf der Leiterplatine 20 vor Feuchtigkeit und Wasser geschützt. Werden für die beiden Steckerbuchsen 31, 32 zudem wasserdichte Ausführungen verwendet, resultiert ein bestmöglicher Schutz gegenüber Feuchtigkeit und Wasser.

Die zweite Steckerbuchse 32 ist zudem von einer in Fig. 2 durch ein gestricheltes Rechteck lediglich angedeuteten Fassung 32.1 umgeben ist. Die Fassung 32.1 dient zur Fixierung und Zentrierung der Steckerbuchse 32 im dritten Gehäuseteil 13.

In Fig. 3 ist ein Querschnitt entlang der Linie C - D aus Fig. 2 dargestellt, welcher in einem Bereich zwischen den Elektronikbausteinen 40 und der kreisförmigen Scheibe 60 bzw. dem Verbindungsring 50 senkrecht zur Längsmittelachse durch das Gehäuse 10 verläuft.

Die im zentralen Bereich von Fig. 3 angeordnete kreisförmige Scheibe 60 ist dabei in ihrem umlaufenden Randbereich vom ersten nicht aufgeweiteten Bereich des ersten hohlzylindrischen Gehäuseteil 11 verdeckt. In der unteren Hälfte verläuft der im Wesentlichen rechteckförmige Schlitz 61 in horizontaler Richtung als Einschnitt von rechts in die kreisförmige Scheibe 60 hinein. Im Schlitz 61 ist die im Querschnitt rechteckförmige Leiterplatine 20 angeordnet. Der Schlitz 61 weist dabei eine in Fig. 3 in vertikaler Richtung verlaufende Schlitzbreite auf, welche einer Dicke der Leiterplatine 20 entspricht. Die in Fig. 3 in horizontaler Richtung verlaufende Schlitzlänge entspricht in etwa der Breite der Leiterplatine 20. Die Leiterplatine 20 liegt mit ihrer linken Seite an der in Fig. 3 links liegenden hinteren Schlitzende 61.1 an. Die Oberseite 20.5 und die Unterseite 20.4 der Leiterplatine liegt zudem auf der gesamten Breite der Leiterplatine 20 an der oberen und der unteren Schlitzbegrenzung an. Somit liegt die Leiterplatine auf der Oberseite 20.5, der Unterseite 20.4 und der linken Seite vollständig an der kreisförmigen Scheibe 60 an bzw. wird von dieser umgeben. Damit wird die Leiterplatine durch die kreisförmige Scheibe 60 bzw. die Trennwand mechanisch im Gehäuse 10 fixiert. Insbesondere das für die Leiterplatine 20 kritische Durchbiegen nach oben oder unten wird so verhindert.

Bis auf eine kleine Öffnung neben der rechten Seite der Leiterplatine 20 besteht wird der Schlitz 61 vollständig von der Leiterplatine 20 ausgefüllt oder durch das erste Gehäuseteil 11 abgedeckt. Zwischen dem ersten Gehäuseteil 11 und dem in Fig. 3 nicht sichtbaren dahinter liegenden zweiten Gehäuseteil 12 besteht also lediglich eine kleine Durchgangsöffnung, so dass die beiden Teilräume 10.1, 10.2 des Gehäuses 10 im Wesentlichen voneinander separiert sind.

Ausserhalb des hohlzylindrischen ersten Gehäuseteils 11 ist in Fig. 3 der quadratische erste Befestigungsflansch 70 zu erkennen, welcher am in Fig. 3 nicht sichtbaren zweiten Gehäuseteil 12 befestigt ist. In den vier Eckbereichen des Befestigungsflansches 70 sind die insgesamt vier Bohrungen 71...74 zu sehen.

In Fig. 4 ist die kreisförmige Scheibe 60 in einer Aufsicht gezeigt. Der Schlitz 61 springt dabei von der rechten Seiten in Fig.4 in horizontaler und nicht-radialer Richtung in der unteren Hälfte der kreisförmigen Scheibe 60 in diese ein. Der Schlitz 61 weist dabei eine obere und eine untere Begrenzung auf, welche im Wesentlichen parallel zueinander verlaufen. Das in Fig. 4 links angeordnete hintere Ende 61.1 des Schlitzes 61 steht senkrecht zu der oberen bzw. unteren Begrenzung des Schlitzes 61. Da der Schlitz 61 nicht vollständig durchgehend ist, besteht die kreisförmige Scheibe 60 aus einem einzigen Stück, was insbesondere bei der Montage von Vorteil ist.

Fig. 5 zeigt den Verbindungsring 50 mit seiner Längsachse in vertikaler Richtung im Detail. Der Verbindungsring 50 ist im Wesentlichen als Hohlzylinder ausgebildet, welcher eine in Fig. 5 oben liegende weite Ringöffnung 52 und eine in Fig. 5 unten liegende enge Ringöffnung 51 aufweist. Die weite Ringöffnung 52 geht dabei etwa in halber Höhe des Verbindungsrings 50 stufenartig in die enge Ringöffnung 51 über.

In Fig. 6 ist die rechteckförmige Leiterplatine 20 in einer Aufsicht auf ihre Oberseite 20.5 abgebildet. Im Bereich des vorderen Endes 20.1 der Leiterplatine 20 ist die erste Steckerbuchse 31 bündig zum vorderen Ende 20.1 angeordnet. Im Bereich des hinteren Endes 20.2 der Leiterplatine 20 ist entsprechend die zweite Steckerbuchse 32 bündig zum hinteren Ende 20.2 angebracht. Wie bei Fig. 2 bereits beschrieben befinden sich zudem die verschiedenen Elektronikbausteine 40, 41 auf der Oberseite 20.5 der Leiterplatine 20. Im mittleren Bereich 20.3 der Leiterplatine 20, zwischen den Elektronikbausteinen 40 und den weiteren Elektronikbausteinen 41 ist zudem der elektrische Erdkontakt 20.6 der Leiterplatine angebracht. Dieser liegt in Form eines rechteckförmigen Metallstreifens vor, welcher mit seiner längeren Seite senkrecht zur Längsachse der rechteckförmigen Leiterplatine verläuft und sich nahezu über die gesamte Breite der Leiterplatine 20 erstreckt. Der Erdkontakt 20.6 wird wie bei Fig. 2 erwähnt z. B. mit der kreisförmigen Scheibe 60 verlötet, so dass ein elektrischer Kontrakt gebildet wird.

Zusätzlich sind auf der Leiterplatine 20 zur Verbindung der Elektronikbausteine 40, 41 auf der Leiterplatine 20 übliche Leiterbahnen eingebracht, welche in Fig. 6 der Übersichtlichkeit halber nicht dargestellt sind.

Fig. 7 zeigt die drei Gehäuseteile 11, 12, 13, den Verbindungsring 50 und die kreisförmige Scheibe 60 vor der Montage in koaxialer Anordnung.

Zur Montage eines Gehäuses 10 mit Leiterplatine 20 wird in einem ersten Verfahrensschritt die fertig bestückte Leiterplatine 20 in den Schlitz 61 der kreisförmigen Scheibe 60 eingeschoben und anschliessend der Erdkontakt 20.6 auf der Leiterplatine 20 mit der kreisförmigen Scheibe verlötet. Im darauf folgenden Verfahrensschritt wird die kreisförmige Scheibe 60 mit eingebrachter Leiterplatine 20 von der Seite der weiten Ringöffnung 52 her durch den Verbindungsring 50 geschoben, bis die kreisförmige Scheibe 60 an der Stufe beim Übergang zur engen Ringöffnung 51 des Verbindungsrings 50 anschlägt. Anschliessend wird die eine Hälfte des Verbindungsrings 50 in den Bereich des zweiten Endes 11.2 des ersten Gehäuseteils 11 mit aufgeweitetem Innendurchmesser bis zum Anschlag eingepresst. Darauf folgend wird die andere Hälfte des Verbindungsring 50 in den Bereich des ersten Endes 12.1 des zweiten Gehäuseteils 12 mit aufgeweitetem Innendurchmesser ebenfalls bis zum Anschlag eingepresst. Scheibe 60 und Verbindungsring 50 werden miteinander verlötet.

Im anschliessenden Verfahrensschritt wird das Gehäuse 10 mit seiner Längsachse in vertikaler Richtung gedreht und von oben her durch die stirnseitige Öffnung des ersten Endes 11.1 des ersten Gehäuseteils 11 Gussmasse eingefüllt. Nach einer kurzen Aushärtephase wird das Gehäuse um 180° gedreht, so dass die Gussmasse durch die Öffnung im Bereich des zweiten Endes 12.2 des zweiten Gehäuseteils 12 eingefüllt werden kann.

Im nächsten Verfahrensschritt erfolgt das Einpressen des ersten und verjüngten Endes 13.1 des dritten Gehäuseteils 13 im Bereich des zweiten Ende 12.2 des zweiten Gehäuseteils 12 mit aufgeweitetem Innendurchmesser.

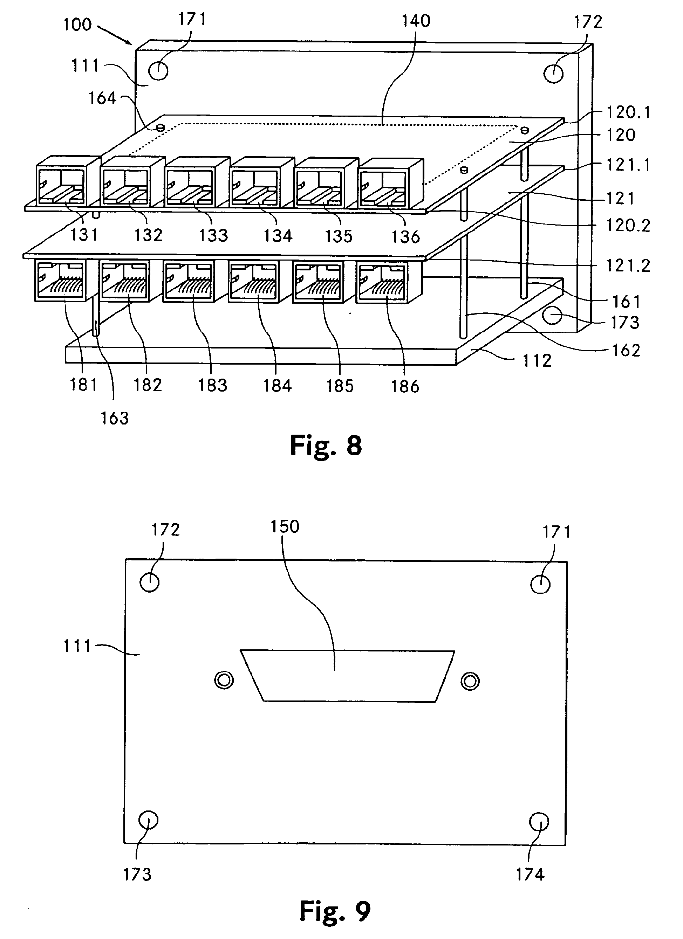

In Fig. 8 ist ein zweites Gehäuse 100 in einer perspektivischen Ansicht dargestellt. Dieses weist eine in Fig. 8 hinten liegende vertikale Frontplatte 111 auf, an welcher in einem unteren Bereich eine nach rechtwinklig vorne nach vorne ragende Bodenplatte 112 angeschweisst ist. Frontplatte 111 als auch Bodenplatte 112 sind aus Aluminium gefertigt. Von jedem der vier Eckbereiche der Bodenplatte 112 ragt ein Haltestift 161, 162, 163, 164, z. B. in Form einer Gewindestange nach oben. Am oberen Ende der vier Haltestifte 161...164 ist eine obere Leiterplatine 120 angeordnet, wobei die vier Haltestifte 161...164 die obere Leiterplatine 120 in einem Bereich zwischen dem vorderen Ende 120.1 der oberen Leiterplatine 120 und deren hinterem Ende 120.2 durchdringen. Die obere Leiterplatine 120 wird dabei z. B. durch nicht dargestellte Schraubenmuttern in bekannter Weise durch die vier Haltestifte 161...164 gehalten. Die Gewindestangen können gleichzeitig als Blitzstromableiter, so dass kein separater Blitzableiter vorgesehen sein muss.

Unterhalb der oberen Leiterplatine 120 ist eine planparallele angeordnete Leiterplatine untere 121 in gleicher Weise an den vier Haltestiften 161...164 befestigt.

Im Bereich des hinteren Endes 120.2 der oberen Leiterplatine 120 sind insgesamt sechs Steckerbuchsen 131...136, welche vom Typ RJ 45 sind, direkt auf der Oberseite der oberen Leiterplatine 120 nebeneinander liegend angebracht. Entsprechend sind auf der unteren Leiterplatine 121 an deren hinterem Ende 121.2 ebenfalls insgesamt sechs weitere Steckerbuchsen 181...186, auch vom Typ RJ 45, direkt auf der Unterseite der untern Leiterplatine 121 nebeneinander liegend angebracht. Die Öffnungen sämtlicher Steckerbuchsen 131...136, 181, 186 ragen dabei in einer zur Frontplatte 111 entgegen gesetzten Richtung.

In einem in Fig. 8 durch ein gestricheltes Rechteck angedeuteten Bauteilbereich 140 sind in bekannter Weise Elektronikbauteile angeordnet. Im vorliegenden Fall handelt es sich z. B. um sechs Blitzschutzschaltungen für sechs Computernetzwerkverbindungen. Analog dazu ist auch die untere Leiterplatine 121 mit beispielsweise sechs Blitzschutzschaltungen ausgestattet. Somit liegen im Gehäuse 100 also insgesamt zwölf Blitzschutzschaltungen für zwölf Computernetzwerkverbindungen vor.

In den Eckbereichen der Frontplatte 111 sind insgesamt vier Befestigungsbohrungen 171...174 eingebracht, welche die Frontplatte vollständig durchdringen.

In Fig. 9 ist eine Aufsicht auf die Frontplatte 111 des Gehäuses 100 aus Fig. 8 abgebildet. In einem zentralen Bereich leicht oberhalb der Mitte der Frontplatte 111 ist dabei ein handelsüblicher fünfzig-poliger Stecker 150 eingebracht, welcher hinter der Frontplatte 111 mit den nicht dargestellten Anschlüssen auf der oberen Leiterplatine 120 und der unteren Leiterplatine 121 elektrisch verbunden ist. Der Stecker150 dient der Ausgabe von Netzwerksignalen. In den vier Eckbereichen der Frontplatte 111 sind zudem die insgesamt vier Bohrungen 171...174 zu erkennen.

Die beschriebenen Ausführungsformen sind lediglich als illustrative Beispiele zu verstehen, welche im Rahmen der Erfindung beliebig erweitert oder abgewandelt werden kann.

So ist es z. B. möglich, anstelle eines zylindrischen Gehäuses 10 in Fig. 1 auch ein im Querschnitt rechteckförmiges Gehäuse zu verwenden. Entsprechend wird in diesem Fall anstelle der kreisförmigen Scheibe 60 als Trennwand eine rechteckförmige Scheibe verwendet.

Ebenso ist es denkbar, die Gehäuseteil 11, 12, 13 zusätzlich oder anstelle des Verpressens durch Verschraubung oder stoffschlüssige Verbindungen (Schweissen, Kleben, Löten) miteinander zu verbinden.

Auch mehrere Trennwände, welche den Innenraum des Gehäuses 10 in mehr als zwei Teilräume unterteilen und die Leiterplatine 20 an mehreren Stellen zwischen dem vorderen Ende 20.1 und den hinteren Ende 20.2 abstützen sind möglich. Dabei kann die Robustheit und mechanische Festigkeit zusätzlich gesteigert werden.

Ebenso kann z. B. auch der dritte Gehäuseteil 13 mit einem weiteren Verbindungsring mit dem zweiten Gehäuseteil 12 verbunden werden.

Auch in einem Gehäuse 10 gemäss Fig. 1 oder 2 können grundsätzlich mehrere Leiterplatinen beispielsweise planparallel übereinander angeordnet werden. Bedingung ist natürlich, dass ausreichend Platz im Gehäuse vorhanden ist. In diesem Fall ist es z. B. auch denkbar, mehrere Steckerbuchsen pro Stirnseite vorzusehen.

Grundsätzlich können natürlich auch Steckerbuchsen im Bereich der Mantelfläche des Gehäuses angebracht werden, wenn dies zweckdienlich ist und als Steckerbuchsen lassen sich auch andere Typen als die beschriebenen RJ 45 Steckerbuchsen verwenden. Weiter ist es denkbar, die Steckerbuchse 31 wegzulassen und stattdessen, das Kabel direkt auf die Leiterplatine zu löten.

Des Weiteren kann die kreisförmige Scheibe 60 z. B. auch ausserhalb des Verbindungsrings 50 direkt im ersten Gehäuseteil 11 oder im zweiten Gehäuseteil 12 angeordnet werden. Hierfür kann z. B. ein Absatz in einem der besagten Gehäuseteile angeordnet werden, welcher als Auflage für die Trennwand dient. Die Trennwand kann prinzipiell auch durch Verschraubung im Gehäuse 10 befestigt werden.

Anstelle einer Blitzschutzschaltung kann natürlich auch eine andere elektronische Schaltung auf der Leiterplatine 20 vorliegen.

Zusammenfassend ist festzustellen, dass ein äusserst kompaktes Gehäuse für Leiterplatinen geschaffen wurde, welches sich insbesondere durch eine hohe Robustheit und einfache Herstellung auszeichnet. Aufgrund der hohen mechanischen Belastbarkeit des Gehäuses ist eine Anwendung in Aussenbereichen, z. B. im militärischen Umfeld, problemlos möglich.

## Patentansprüche

1. Vorrichtung, umfassend eine in einem Gehäuse (10, 100) angeordnete Leiterplatine (20, 120, 121) für eine elektrische und/oder elektronische Schaltung, wobei die Leiterplatine (20, 120, 121) einen vorderen Bereich (20.1, 120.1, 121.1) und einen hinteren Bereich (20.2, 120.2, 121.2) aufweist, wobei die Leiterplatine (20, 120, 121) zwischen dem vorderen Bereich (20.1, 120.1, 121.1) und dem hinteren Bereich (20.2, 120.2, 121.2) mechanisch im Gehäuse (10, 100) abgestützt ist, wobei ein Innenraum des Gehäuses durch eine Trennwand (60) in zwei Teilräume (10.1, 10.2) separiert ist,
**dadurch gekennzeichnet,**
**dass**. die Leiterplatine (20) durch einen in der Trennwand (60) eingebrachten Schlitz (61) hindurch ragt und
durch die Trennwand (60) abgestützt ist.

2. Vorrichtung nach Anspruch 1, **dadurch gekennzeichnet, dass** der Schlitz (61) in der Trennwand (60) derart dimensioniert ist, dass dieser von einem im Schlitz (61) vorliegenden Bereich (20.3) der Leiterplatine (20) vollständig ausgefüllt ist.

3. Vorrichtung nach Anspruch 1 oder 2, **dadurch gekennzeichnet, dass** die Leiterplatine (20) senkrecht zur Trennwand (60) angeordnet ist.

4. Vorrichtung nach einem der Ansprüche 1 - 3, **dadurch gekennzeichnet, dass** die Trennwand (60) aus Metall, insbesondere aus Kupfer, besteht und mit einem in der Leiterplatine (20) eingebrachten elektrischen Kontakt (20.6), insbesondere einem Erdkontakt, elektrisch verbunden ist.

5. Vorrichtung nach Anspruch 4, **dadurch gekennzeichnet, dass** der in der Leiterplatine (20) eingebrachte elektrische Kontakt (20.6) wenigstens teilweise im Schlitz (61) der Trennwand (60) angeordnet ist und zur elektrischen Kontaktierung mit der Trennwand (60) verlötet ist.

6. Vorrichtung nach einem der Ansprüche 1 - 5, **dadurch gekennzeichnet, dass** die Trennwand (60) und das Gehäuse (10) elektrisch verbunden sind.

7. Vorrichtung nach einem der Ansprüche 1 - 6, **dadurch gekennzeichnet, dass** das Gehäuse (10) röhrenförmig mit kreisrundem Querschnitt ausgebildet ist und dass die Trennwand (60) als kreisförmige Scheibe vorliegt, welche senkrecht zu einer Längsachse des Gehäuses (10) ausgerichtet ist.

8. Vorrichtung nach Anspruch 7, **dadurch gekennzeichnet, dass** das röhrenförmige Gehäuse (10) mehrteilig ausgebildet ist, wobei ein erster röhrenförmiger Gehäuseteil (11) über einen innwenig und koaxial angeordneten Verbindungsring (50) stirnseitig mit einem zweiten röhrenförmigen Gehäuseteil (12) verbunden ist.

9. Vorrichtung nach Anspruch 8, **dadurch gekennzeichnet, dass** der Verbindungsring (50) mit einer ersten Hälfte kraftschlüssig und formschlüssig in einem Endbereich (11.2) mit vergrösserten Innendurchmesser des ersten röhrenförmigen Gehäuseteils (11) aufgenommen ist, während der Verbindungsring (50) mit einer zweiten Hälfte gleichzeitig kraftschlüssig und formschlüssig in einem zweiten Endbereich (12.1) mit vergrösserten Innendurchmesser des zweiten röhrenförmigen Gehäuseteils (12) aufgenommen ist.

10. Vorrichtung nach Anspruch 8 oder 9, **dadurch gekennzeichnet, dass** die kreisförmige Scheibe (60) im Verbindungsring (50) aufgenommen ist, wobei ein Durchmesser der kreisförmigen Scheibe (60) einem Innendurchmesser des Verbindungsrings (50) entspricht und wobei die kreisförmige Scheibe (60) bevorzugt an einem nach innen ragenden Vorstand des Verbindungsrings (50) anliegt.

11. Vorrichtung nach einem der Ansprüche 7 - 10, **dadurch gekennzeichnet, dass** der in der kreisförmigen Scheibe (60) vorliegende Schlitz (61) in nichtradialer Richtung verläuft.

12. Vorrichtung nach einem der Ansprüche 1 - 11, **dadurch gekennzeichnet, dass** das Gehäuse (10, 100) aus Metall, insbesondere aus Aluminium, besteht.

13. Vorrichtung nach einem der Ansprüche 1 - 12, **dadurch gekennzeichnet, dass** auf der Leiterplatine (20) eine Blitzschutzschaltung, insbesondere für eine Computernetzwerkverbindung, angeordnet ist.

14. Vorrichtung nach einem der Ansprüche 1 - 13, **dadurch gekennzeichnet, dass** die Leiterplatine (20) zum Schutz vor Feuchtigkeit und Fremdkörpern wenigstens teilweise von einer Gussmasse umgeben ist.

15. Vorrichtung nach einem der Ansprüche 1 - 14, **dadurch gekennzeichnet, dass** an einer vorderen Stirnseite und/oder an einer hinteren Stirnseite des Gehäuses (10) eine Steckerbuchse (31, 32) zur elektrischen Verbindung mit einem externen Kabel vorliegt, wobei die Steckerbuchse (31, 32) bevorzugt direkt auf der Leiterplatine (20) angebracht ist.

16. Vorrichtung nach einem der Ansprüche 1 - 15, **dadurch gekennzeichnet, dass** das Gehäuse (10) an einer Aussenseite über einen oder mehrere Vorsprünge (70, 80) zur Befestigung des Gehäuses (10) an einem Drittelement verfügt, wobei die Vorsprünge (70, 80) insbesondere Befestigungsbohrungen (71...74, 81...84) aufweisen.

17. Vorrichtung nach einem der Ansprüche 1 - 16, **dadurch gekennzeichnet, dass** wenigstens zwei Leiterplatinen (120, 121) planparallel und beabstandet übereinander liegend angeordnet sind.

18. Verfahren zu Herstellung eines Gehäuses (10) mit einer Leiterplatine (20) nach einem der Ansprüche 7 - 17, **dadurch gekennzeichnet, dass** eine Leiterplatine (20) in einen Schlitz (61) einer kreisförmigen Scheibe (60) eingeschoben wird und die Scheibe (60) anschliessend in einem Verbindungsring (50) aufgenommen wird und danach der Verbindungsring (50) mit einer ersten Hälfte in einem stirnseitigen Endbereich (11.2) eines ersten röhrenförmigen Gehäuseteils (11) verklemmt wird und anschliessend der Verbindungsring (50) mit einer zweiten Hälfte in einen zweiten Endbereich (12.1) eines zweiten röhrenförmigen Gehäuseteils (12) verklemmt wird.

## Claims

1. Apparatus comprising a printed circuit board (20, 120, 121) for an electrical and/or electronic circuit, which printed circuit board is arranged in a housing (10, 100), the printed circuit board (20, 120, 121) having a front region (20.1, 120.1, 121.1) and a rear region (20.2, 120.2, 121.2), the printed circuit board (20, 120, 121) being mechanically supported in the housing (10, 100) between the front region (20.1, 120.1, 121.1) and the rear region (20.2, 120.2, 121.2), an internal space of the housing being separated into two subspaces (10.1, 10.2) by a partition wall (60),
**characterized**
**in that** the printed circuit board (20) projects through a slot (61) made in the partition wall (60) and is supported by the partition wall (60).

2. Apparatus according to Claim 1, **characterized in that** the slot (61) in the partition wall (60) is dimensioned in such a manner that it is completely filled by a region (20.3) of the printed circuit board (20) in the slot (61).

3. Apparatus according to Claim 1 or 2, **characterized in that** the printed circuit board (20) is arranged perpendicular to the partition wall (60).

4. Apparatus according to one of Claims 1-3, **characterized in that** the partition wall (60) consists of metal, in particular of copper, and is electrically connected to an electrical contact (20.6), in particular an earth contact, made in the printed circuit board (20).

5. Apparatus according to Claim 4, **characterized in that** the electrical contact (20.6) made in the printed circuit board (20) is at least partially arranged in the slot (61) in the partition wall (60) and is soldered to the partition wall (60) for the purpose of making electrical contact.

6. Apparatus according to one of Claims 1-5, **characterized in that** the partition wall (60) and the housing (10) are electrically connected.

7. Apparatus according to one of Claims 1-6, **characterized in that** the housing (10) is tubular with a circular cross section, and **in that** the partition wall (60) is in the form of a circular disc which is oriented perpendicular to a longitudinal axis of the housing (10).

8. Apparatus according to Claim 7, **characterized in that** the tubular housing (10) has a multi-part design, the end face of a first tubular housing part (11) being connected to a second tubular housing part (12) via an internally and coaxially arranged connecting ring (50).

9. Apparatus according to Claim 8, **characterized in that** a first half of the connecting ring (50) is accommodated in a force-fitting and form-fitting manner in an end region (11.2) of increased internal diameter of the first tubular housing part (11), while a second half of the connecting ring (50) is simultaneously accommodated in a force-fitting and form-fitting manner in a second end region (12.1) of increased internal diameter of the second tubular housing part (12).

10. Apparatus according to Claim 8 or 9, **characterized in that** the circular disc (60) is accommodated in the connecting ring (50), a diameter of the circular disc (60) corresponding to an internal diameter of the connecting ring (50), and the circular disc (60) preferably resting against an inwardly projecting protrusion of the connecting ring (50).

11. Apparatus according to one of Claims 7-10, **characterized in that** the slot (61) in the circular disc (60) runs in a non-radial direction.

12. Apparatus according to one of Claims 1-11, **characterized in that** the housing (10, 100) consists of metal, in particular of aluminium.

13. Apparatus according to one of Claims 1-12, **characterized in that** a lightning protection circuit, in particular for a computer network connection, is arranged on the printed circuit board (20).

14. Apparatus according to one of Claims 1-13, **characterized in that** the printed circuit board (20) is at least partially surrounded by a potting compound in order to protect against moisture and foreign bodies.

15. Apparatus according to one of Claims 1-14, **characterized in that** a connector socket (31, 32) for electrical connection to an external cable is present on a front end face and/or on a rear end face of the housing (10), the connector socket (31, 32) preferably being directly fitted to the printed circuit board (20).

16. Apparatus according to one of Claims 1-15, **characterized in that** the housing (10) has, on an outer side, one or more projections (70, 80) for fastening the housing (10) to a third element, the projections (70, 80) having fastening holes (71...74, 81...84), in particular.

17. Apparatus according to one of Claims 1-16, **characterized in that** at least two printed circuit boards (120, 121) are arranged above one another in a plane-parallel manner and at a distance from one another.

18. Method for producing a housing (10) having a printed circuit board (20) according to one of Claims 7-17, **characterized in that** a printed circuit board (20) is inserted into a slot (61) in a circular disc (60) and the disc (60) is then accommodated in a connecting ring (50) and a first half of the connecting ring (50) is then clamped in an end region (11.2) on the end face of a first tubular housing part (11) and a second half of the connecting ring (50) is then clamped in a second end region (12.1) of a second tubular housing part (12).

## Revendications

1. Dispositif comprenant un circuit imprimé (20, 120, 121) disposé dans un boîtier (10, 100) pour un circuit électrique et/ou électronique, le circuit imprimé (20, 120, 121) présentant une zone avant (20.1, 121.1, 121.1) et une zone arrière (20.2, 120.2, 121.2), le circuit imprimé (20, 120, 121) étant soutenu mécaniquement dans le boîtier (10, 100) entre la zone avant (20.1, 121.1, 121.1) et la zone arrière (20.2, 120.2, 121.2), un espace intérieur du boîtier étant séparé en deux espaces partiels (10.1, 10.2) par une paroi de séparation (60),
**caractérisé en ce**
**que** le circuit imprimé (20) fait saillie à travers une fente (61) aménagée dans la paroi de séparation (60) et est soutenu par la paroi de séparation (60).

2. Dispositif selon la revendication 1, **caractérisé en ce que** la fente (61) dans la paroi de séparation (60) est dimensionnée de telle sorte que celle-ci est entièrement remplie par une zone (20.3) du circuit imprimé (20) qui est présente dans la fente (61).

3. Dispositif selon la revendication 1 ou 2, **caractérisé en ce que** le circuit imprimé (20) est disposé perpendiculairement à la paroi de séparation (60).

4. Dispositif selon l'une des revendications 1 à 3, **caractérisé en ce que** la paroi de séparation (60) se compose de métal, notamment de cuivre, et est reliée électriquement avec un contact électrique (20.6) introduit dans le circuit imprimé (20), notamment un contact de terre.

5. Dispositif selon la revendication 4, **caractérisé en ce que** le contact électrique (20.6) introduit dans le circuit imprimé (20) est disposé au moins partiellement dans la fente (61) de la paroi de séparation (60) et est fixé par brasage pour établir le contact électrique avec la paroi de séparation (60).

6. Dispositif selon l'une des revendications 1 à 5, **caractérisé en ce que** la paroi de séparation (60) et le boîtier (10) sont reliés électriquement.

7. Dispositif selon l'une des revendications 1 à 6, **caractérisé en ce que** le boîtier (10) est réalisé en forme de tube avec une section transversale circulaire et **en ce que** la paroi de séparation (60) se présente sous la forme d'une plaque circulaire qui est orientée perpendiculairement à un axe longitudinal du boîtier (10).

8. Dispositif selon la revendication 7, **caractérisé en ce que** le boîtier (10) en forme de tube est réalisé en plusieurs parties, une première partie de boîtier (11) en forme de tube étant reliée du côté frontal avec une deuxième partie de boîtier (12) en forme de tube par le biais d'une bague de liaison (50) intérieure et disposée de manière coaxiale.

9. Dispositif selon la revendication 8, **caractérisé en ce que** la bague de liaison (50) est logée avec une première moitié par adhérence et par complémentarité de forme dans une zone d'extrémité (11.2) ayant un diamètre intérieur agrandi de la première partie de boîtier (11) en forme de tube, alors que la bague de liaison (50) est logée avec une deuxième moitié à la fois par adhérence et par complémentarité de forme dans une deuxième zone d'extrémité (12.1) ayant un diamètre intérieur agrandi de la deuxième partie de boîtier (12) en forme de tube.

10. Dispositif selon la revendication 8 ou 9, **caractérisé en ce que** la plaque circulaire (60) est logée dans la bague de liaison (50), un diamètre de la plaque circulaire (60) correspondant à un diamètre intérieur de la bague de liaison (50) et la plaque circulaire (60) reposant de préférence sur un surplomb faisant saillie vers l'intérieur de la bague de liaison (50).

11. Dispositif selon l'une des revendications 7 à 10, **caractérisé en ce que** la fente (61) présente dans la plaque circulaire (60) s'étend dans une direction non radiale.

12. Dispositif selon l'une des revendications 1 à 11, **caractérisé en ce que** le boîtier (10, 100) se compose de métal, notamment d'aluminium.

13. Dispositif selon l'une des revendications 1 à 12, **caractérisé en ce qu'**un circuit de protection contre la foudre, notamment pour une liaison de réseau informatique, est disposé sur le circuit imprimé (20).

14. Dispositif selon l'une des revendications 1 à 13, **caractérisé en ce que** le circuit imprimé (20) est entouré au moins partiellement par une masse de moulage pour sa protection contre l'humidité et les corps étrangers.

15. Dispositif selon l'une des revendications 1 à 14, **caractérisé en ce qu'**une prise de connexion (31, 32) destinée à la liaison électrique avec un câble externe est présente sur un côté frontal avant et/ou sur un côté frontal arrière du boîtier (10), la prise de connexion (31, 32) étant de préférence montée directement sur le circuit imprimé (20).

16. Dispositif selon l'une des revendications 1 à 15, **caractérisé en ce que** le boîtier (10) dispose sur un côté extérieur d'une ou plusieurs parties en saillie (70, 80) pour la fixation du boîtier (10) à un élément tiers, les parties en saillie (70, 80) présentant notamment des orifices de fixation (71 ... 74, 81 ... 84).

17. Dispositif selon l'une des revendications 1 à 16, **caractérisé en ce qu'**au moins deux circuits imprimés (120, 121) sont disposés avec leurs faces parallèles et espacés l'un au-dessus de l'autre.

18. Procédé de fabrication d'un boîtier (10) comprenant un circuit imprimé (20) selon l'une des revendications 7 à 17, **caractérisé en ce qu'**un circuit imprimé (20) est inséré dans une fente (61) d'une plaque circulaire (60) et la plaque (60) est ensuite logée dans une bague de liaison (50) et la bague de liaison (50) est ensuite coincée avec une première moitié dans une zone d'extrémité (11.2) côté frontal d'une première partie de boîtier (11) en forme de tube et la bague de liaison (50) est ensuite coincée avec une deuxième moitié dans une deuxième zone d'extrémité (12.1) d'une deuxième partie de boîtier (12) en forme de tube.
